# EUROPEAN PATENT SPECIFICATION

(11) **EP 4 027 323 B1**
(45) Date of publication and mention of the grant of the patent: **22.10.2025**
(21) Application number: 20882764.2
(22) Date of filing: 24.07.2020
(51) Int. Cl.: G06F 1/16, G09F 9/30

(54) **FLEXIBLE DISPLAY SCREEN AND DISPLAY TERMINAL**
FLEXIBLER ANZEIGEBILDSCHIRM UND ANZEIGEENDGERÄT
ÉCRAN D'AFFICHAGE FLEXIBLE ET TERMINAL D'AFFICHAGE

(30) Priority: 28.10.2019 CN 201911030645
(43) Date of publication of application: 13.07.2022
(73) Proprietor: Huawei Technologies Co., Ltd., Longgang District Shenzhen, Guangdong 518129 (CN)
(72) Inventor: PAN, Liangyu, Shenzhen, Guangdong 518129 (CN); WANG, Lei, Shenzhen, Guangdong 518129 (CN); YAN, Yuan, Shenzhen, Guangdong 518129 (CN); PANG, Yongqiang, Shenzhen, Guangdong 518129 (CN); LI, Haiyan, Shenzhen, Guangdong 518129 (CN); LIU, Yang, Shenzhen, Guangdong 518129 (CN)
(74) Representative: Pfenning, Meinig & Partner mbB
(86) International application number: PCT/CN2020/104657
(87) International publication number: WO 2021/082554

(56) References cited:
- CN-A- 104 103 217
- CN-A- 106 157 819
- CN-A- 106 601 130
- CN-A- 107 358 874
- CN-A- 108 205 973
- CN-A- 109 064 895
- CN-A- 109 830 185
- CN-A- 109 859 630
- CN-A- 110 035 140
- US-A1- 2018 182 985

## Description

### TECHNICAL FIELD

This application relates to the field of display technologies, and in particular, to a flexible display screen and a display terminal.

### BACKGROUND

Organic light-emitting diode (Organic Light Emitting Diode, OLED) is a current-type light-emitting device, which is increasingly applied to the field of high-performance display because of its characteristics such as self-illumination, a fast response, and a wide field of view. When a substrate that is in a flexible display screen and that is used to carry OLED light-emitting devices is a flexible substrate, the flexible display screen may be a flexible display screen, so that the display screen can be bent.

Currently, in a process of manufacturing the display screen, a part of a non-luminous area of the flexible display screen may be bent to a back surface of the display screen, to reduce a border size of the display screen, so that the display screen can reach a larger screen-to-body ratio. However, during use of the flexible display screen, when a user bends the flexible display screen, stress easily concentrates and folds accumulate where the part that is of the non-luminous area and that has been bent to the back surface of the display screen is bent again, resulting in a folding failure or other problems of the screen.

US 2018/182985 A1 discloses a foldable display device includes a flexible substrate which includes a display area, a bezel area enclosing the display area, and a plurality of bending areas extending from one side of the bezel area; and a display unit disposed in the display area, in which the plurality of bending areas is separated from each other.

### SUMMARY

The present invention is set out in the appended set of claims. Embodiments of this application provide a flexible display screen and a display terminal, to reduce a probability that a stress concentration problem occurs because a non-luminous area of a display screen is folded a plurality of times.

To achieve the foregoing objective, the following technical solutions are used in this application:
According to a first aspect of the embodiments of this application, a display terminal is provided. The display terminal includes a support component and a flexible display screen. The support component includes a first housing, a second housing, and a rotating shaft. The rotating shaft is located between the first housing and the second housing. The first housing and the second housing are connected by rotating the rotating shaft. A back surface of the flexible display screen is connected to the first housing, the second housing, and the rotating shaft. A part that is of the flexible display screen and that is connected to the rotating shaft is used as a first bent portion. The first bent portion is configured to bend along an axis of the rotating shaft, to fold in half a part that is of the flexible display screen and that is separately connected to the first housing and the second housing. The flexible display screen has a luminous area and a non-luminous area that is disposed on a periphery of the luminous area. In addition, the flexible display screen includes a first peripheral portion and a second peripheral portion. The first peripheral portion and the second peripheral portion are in the non-luminous area, and are disposed side by side on a same side of the luminous area. A part that is of the first peripheral portion and that is bent to the back surface of the flexible display screen faces the first housing. A part that is of the second peripheral portion and that is bent to the back surface of the flexible display screen faces the second housing. A first notch is in the non-luminous area, disposed on a side of the first bent portion, and located between the first peripheral portion and the second peripheral portion. In this way, by disposing the first notch, a part that is in the non-luminous area of the flexible display screen and that is configured to couple to a drive chip may be segmented to form a plurality of peripheral portions, for example, the first peripheral portion and the second peripheral portion. By bending each peripheral portion separately, a length of a bent part in the non-luminous area can be reduced, to improve a bending yield rate. In addition, because the first notch is located on the side of the first bent portion and disposed between the first peripheral portion and the second peripheral portion, when the first bent portion is bent, no stress is generated at a position of the first notch. In this way, a probability that a stress concentration problem occurs because the non-luminous area of the flexible display screen is folded a plurality of times can be reduced.

The flexible display screen further includes a plurality of data lines. The first peripheral portion includes a multiplexer and a plurality of pads coupled to the multiplexer. The multiplexer is configured to couple to the data lines. After the first peripheral portion is bent in a direction perpendicular to the axis of the rotating shaft, the multiplexer and the pads are disposed on the back surface of the flexible display screen. The pads may be coupled to the drive chip. In this way, after the multiplexer and the pads disposed on the first peripheral portion are bent to the back surface of the flexible display screen, the drive chip that is of a relatively large size may be disposed on the back surface of the flexible display screen, to reduce a border size of the flexible display screen. Similarly, a part on which a multiplexer and pads are disposed on the second peripheral portion may also be bent to the back surface of the flexible display screen. With a separation effect of the first notch between the first peripheral portion and the second peripheral portion, when the first peripheral portion and the second peripheral portion are bent separately, a probability that a phenomenon such as pulling or wrinkling occurs on parts that are on different peripheral portions and that are configured to couple to the drive chip can be reduced.

Optionally, the flexible display screen further includes a fan-out portion. The fan-out portion is located between the luminous area and the peripheral portions. The fan-out portion includes a plurality of fan-out leads. A first end of the fan-out lead is coupled to the multiplexer, and a second end is coupled to the data line. The fan-out lead close to the first notch is disposed bypassing an edge of the first notch. In this way, when a data line on the flexible display screen is coupled to the multiplexer on the peripheral portion by using a fan-out lead in the fan-out portion, the fan-out lead may be disposed bypassing the edge of the first notch, so that the data line can normally receive a data voltage, and the flexible display screen can normally perform display, without being affected by the first notch.

Optionally, the flexible display screen further includes a third peripheral portion, a fourth peripheral portion, and a second notch. The second notch is located between the third peripheral portion and the fourth peripheral portion, and the third peripheral portion, the fourth peripheral portion, and the first peripheral portion are located on a same side of the non-luminous area. Parts that are of the third peripheral portion and the fourth peripheral portion and that are bent to the back surface of the flexible display screen both face the first housing. In this way, a quantity of segments in the non-luminous area may be further increased, to reduce a length of a bent part in the non-luminous area, and improve a bending yield rate.

Optionally, the first notch and the second notch have a same shape. In addition, in a direction perpendicular to the axis of the rotating shaft, an opening width of the first notch is the same as an opening width of the second notch. In this way, manufacturing processes and process parameters for forming the first notch and the second notch on the flexible display screen may be the same, so that the manufacturing process can be simplified.

Optionally, in a direction perpendicular to the axis of the rotating shaft, an opening width of the first notch is greater than a width of the first bent portion. In this way, after parts that are on the first peripheral portion and the second peripheral portion and that are respectively configured to couple to a drive chip are bent to the back surface of the flexible display screen, when the flexible display screen is folded in half at a position that is on the flexible display screen and that corresponds to the first bent portion, a position of the first bent portion does not crush the parts that are of the first peripheral portion and the second peripheral portion and that are bent to the back surface of the flexible display screen, thereby reducing a probability of a phenomenon such as pulling or wrinkling.

Optionally, the luminous area is a rectangle, and the first peripheral portion and the second peripheral portion are located on a long side of the luminous area. In this way, each data line coupled to the drive chip on the peripheral portion is disposed along the axis of the rotating shaft, that is, a short side of the luminous area. Compared with a solution in which the data line is disposed in the direction perpendicular to the axis of the rotating shaft, that is, along the long side of the luminous area, a routing length of the data line can be greatly reduced, thereby reducing a signal transmission loss of the data line and a load resistance, improving a driving capability of the drive chip, and mitigating uneven display caused by a signal delay in a signal transmission process of the data line.

Optionally, the flexible display screen further includes a first gate drive circuit and a second gate drive circuit. The first gate drive circuit is in the non-luminous area, and disposed on a side on which a first short side of the luminous area is located. The first gate drive circuit is configured to provide a gate drive signal for at least a part of the luminous area. The second gate drive circuit is in the non-luminous area, and disposed on a side on which a second short side of the luminous area is located. The second gate drive circuit is configured to provide a gate drive signal for at least a part of the luminous area. The first short side and the second short side are disposed opposite to each other. The first gate drive circuit and the second gate drive circuit may be integrated on a flexible substrate of the flexible display screen. Therefore, compared with a solution of separately coupling to gate drive chips, border widths of the flexible display screen on left and right sides can be reduced, thereby implementing a narrow-border design.

Optionally, in a second direction, a width of the first gate drive circuit is the same as a width of the second gate drive circuit. In this way, the border widths of the flexible display screen on the left and right sides may also be the same, so that the left and right sides of the luminous area of the flexible display screen are symmetric, thereby improving overall aesthetics of the screen.

The display terminal further includes a drive chip coupled to the pads. The drive chip may provide a data signal for the data lines of the flexible display screen by using the pads. According to a second aspect of the embodiments of this application, a flexible display screen is provided. A back surface of the flexible display screen is configured to connect to a first housing, a second housing, and a rotating shaft in a support component. The rotating shaft is located between the first housing and the second housing. The first housing and the second housing are connected by rotating the rotating shaft. A part that is of the flexible display screen and that is connected to the rotating shaft is used as a first bent portion. The first bent portion is configured to bend along an axis of the rotating shaft, to fold in half a part that is of the flexible display screen and that is separately connected to the first housing and the second housing. The flexible display screen has a luminous area and a non-luminous area that is disposed on a periphery of the luminous area. In addition, the flexible display screen includes a first peripheral portion and a second peripheral portion. The first peripheral portion and the second peripheral portion are in the non-luminous area, and are disposed side by side on a same side of the luminous area. A part that is of the first peripheral portion and that is bent to the back surface of the flexible display screen faces the first housing. A part that is of the second peripheral portion and that is bent to the back surface of the flexible display screen faces the second housing. A first notch is in the non-luminous area, disposed on a side of the first bent portion, and located between the first peripheral portion and the second peripheral portion. In this way, by disposing the first notch, a part that is in the non-luminous area of the flexible display screen and that is configured to couple to a drive chip may be segmented to form a plurality of peripheral portions, for example, the first peripheral portion and the second peripheral portion. By bending each peripheral portion separately, a length of a bent part in the non-luminous area can be reduced, and a bending yield rate can be improved. In addition, because the first notch is located on a side of the first bent portion and disposed between the first peripheral portion and the second peripheral portion, when the first bent portion is bent, no stress is generated at a position of the first notch. In this way, a probability that a stress concentration problem occurs because the non-luminous area of the flexible display screen is folded a plurality of times can be reduced.

Optionally, the flexible display screen further includes a plurality of data lines. The first peripheral portion includes a multiplexer and a plurality of pads coupled to the multiplexer. The multiplexer is configured to couple to the data lines. After the first peripheral portion is bent in a direction perpendicular to the axis of the rotating shaft, the multiplexer and the pads are disposed on the back surface of the flexible display screen. The pads may be coupled to a drive chip. In this way, after the multiplexer and the pads disposed on the first peripheral portion are bent to the back surface of the flexible display screen, a drive chip with a relatively large size may be disposed on the back surface of the flexible display screen, to reduce a border size of the flexible display screen. Similarly, a part on which a multiplexer and pads are disposed on the second peripheral portion may also be bent to the back surface of the flexible display screen. With a separation effect of the first notch between the first peripheral portion and the second peripheral portion, when the first peripheral portion and the second peripheral portion are bent separately, a probability that a phenomenon such as pulling or wrinkling occurs on parts that are on different peripheral portions and that are configured to couple to a drive chip can be reduced.

Optionally, the flexible display screen further includes a fan-out portion. The fan-out portion is located between the luminous area and the peripheral portions. The fan-out portion includes a plurality of fan-out leads. A first end of a fan-out lead is coupled to the multiplexer, and a second end is coupled to a data line. A fan-out lead close to the first notch is disposed bypassing an edge of the first notch. In this way, when a data line on the flexible display screen is coupled to the multiplexer on the peripheral portion by using a fan-out lead in the fan-out portion, the fan-out lead may be disposed bypassing the edge of the first notch, so that the data line can normally receive a data voltage, and the flexible display screen can normally perform display, without being affected by the first notch.

Optionally, the flexible display screen further includes a third peripheral portion, a fourth peripheral portion, and a second notch. The second notch is located between the third peripheral portion and the fourth peripheral portion, and the third peripheral portion, the fourth peripheral portion, and the first peripheral portion are located on a same side of the non-luminous area. Parts that are of the third peripheral portion and the fourth peripheral portion and that are bent to the back surface of the flexible display screen both face the first housing. In this way, a quantity of segments in the non-luminous area may be further increased, to reduce a length of a bent part in the non-luminous area, and improve a bending yield rate.

Optionally, the first notch and the second notch have a same shape. In addition, in a direction perpendicular to the axis of the rotating shaft, an opening width of the first notch is the same as an opening width of the second notch. In this way, manufacturing processes and process parameters for forming the first notch and the second notch on the flexible display screen may be the same, so that the manufacturing process can be simplified.

Optionally, in a direction perpendicular to the axis of the rotating shaft, an opening width of the first notch is greater than a width of the first bent portion. In this way, after parts that are on the first peripheral portion and the second peripheral portion and that are respectively configured to couple to a drive chip are bent to the back surface of the flexible display screen, when the flexible display screen is folded in half at a position that is on the flexible display screen and that corresponds to the first bent portion, a position of the first bent portion does not crush the parts that are of the first peripheral portion and the second peripheral portion and that are bent to the back surface of the flexible display screen, thereby reducing a probability of a phenomenon such as pulling or wrinkling.

Optionally, the luminous area is a rectangle, and the first peripheral portion and the second peripheral portion are located on a long side of the luminous area. In this way, each data line coupled to the drive chip on the peripheral portion is disposed along the axis of the rotating shaft, that is, a short side of the luminous area. Compared with a solution in which the data line is disposed in the direction perpendicular to the axis of the rotating shaft, that is, along the long side of the luminous area, a data line routing length can be greatly reduced, thereby reducing a signal transmission loss of the data line and a load resistance, improving a driving capability of the drive chip, and mitigating uneven display caused by a signal delay in a signal transmission process of the data line.

Optionally, the flexible display screen further includes a first gate drive circuit and a second gate drive circuit. The first gate drive circuit is in the non-luminous area, and disposed on a side on which a first short side of the luminous area is located. The first gate drive circuit is configured to provide a gate drive signal for at least a part of the luminous area. The second gate drive circuit is in the non-luminous area, and disposed on a side on which a second short side of the luminous area is located. The second gate drive circuit is configured to provide a gate drive signal for at least a part of the luminous area. The first short side and the second short side are disposed opposite to each other. The first gate drive circuit and the second gate drive circuit may be integrated on a flexible substrate of the flexible display screen. Therefore, compared with a solution of separately coupling to gate drive chips, border widths of the flexible display screen on left and right sides can be reduced, thereby implementing a narrow-border design.

Optionally, in a second direction, a width of the first gate drive circuit is the same as a width of the second gate drive circuit. In this way, the border widths of the flexible display screen on the left and right sides may also be the same, so that the left and right sides of the luminous area of the flexible display screen are symmetric, thereby improving overall aesthetics of the screen.

### BRIEF DESCRIPTION OF DRAWINGS

FIG. 1a is a schematic structural diagram of a display terminal according to an embodiment of this application;
FIG. 1b is a schematic structural diagram of a flexible display screen according to an embodiment of this application;
FIG. 2 is a cross-sectional view of a flexible display screen according to an embodiment of this application;
FIG. 3 is a schematic structural diagram of a pixel circuit in a sub pixel in FIG. 1b;
FIG. 4a is a schematic diagram of a manner of disposing a display portion and a first bent portion of a flexible display screen according to an embodiment of this application;
FIG. 4b is a schematic diagram of a manner of folding the flexible display screen shown in FIG. 4a;
FIG. 5a is a schematic diagram of another manner of disposing a display portion and a first bent portion of a flexible display screen according to an embodiment of this application;
FIG. 5b is a schematic diagram of another manner of folding the flexible display screen shown in FIG. 5a;
FIG. 6a is a schematic diagram of a manner of coupling a flexible display screen and an external drive circuit according to an embodiment of this application;
FIG. 6b is a schematic structural diagram of a flexible display screen on which a gate drive circuit is disposed according to an embodiment of this application;
FIG. 6c is another schematic structural diagram of a flexible display screen on which a gate drive circuit is disposed according to an embodiment of this application;
FIG. 7a is a schematic structural diagram of a non-luminous area of a flexible display screen according to an embodiment of this application;
FIG. 7b is another schematic structural diagram of a non-luminous area of a flexible display screen according to an embodiment of this application;
FIG. 7c is another schematic structural diagram of a non-luminous area of a flexible display screen according to an embodiment of this application;
FIG. 7d is another schematic structural diagram of a non-luminous area of a flexible display screen according to an embodiment of this application;
FIG. 8a is a schematic diagram of a manner of bending a non-luminous area of a flexible display screen according to an embodiment of this application;
FIG. 8b is a schematic diagram of another manner of bending a non-luminous area of a flexible display screen according to an embodiment of this application;
FIG. 9a is a schematic diagram of another manner of bending a non-luminous area of a flexible display screen according to an embodiment of this application;
FIG. 9b is a schematic diagram of another manner of bending a non-luminous area of a flexible display screen according to an embodiment of this application;
FIG. 10 is another schematic structural diagram of a non-luminous area of a flexible display screen according to an embodiment of this application;
FIG. 11 is another schematic structural diagram of a non-luminous area of a flexible display screen according to an embodiment of this application;
FIG. 12a, FIG. 12b, FIG. 12c, and FIG. 12d are respectively schematic structural diagrams corresponding to processes of manufacturing a flexible display screen; and
FIG. 13 is a schematic diagram of cutting a flexible display screen according to an embodiment of this application.

### Reference numerals:

01: display terminal; 10: flexible display screen; 70: support component; 701: first housing; 702: second housing; 703: rotating shaft; 300: first bent portion; 20: sub pixel; 101: luminous area; 102: non-luminous area; 201: OLED device; 11: flexible substrate; 12: recess; 21: pixel define layer; 121: first electrode; 120: organic light-emitting layer; 122: second electrode; 02: pixel drive circuit; 200a: first display portion; 200b: second display portion; 200c: third display portion; 30: gate drive circuit; 30a: first gate drive circuit; 30b: second gate drive circuit; 31: drive chip; 32: flexible printed circuit; 40a: first peripheral portion; 40b: second peripheral portion; 411: MUX; 412: pad; 40c: third peripheral portion; 40d: fourth peripheral portion; 41: fan-out portion; 50: first notch; 51: second notch; 401: external lead connection portion; 402: second bent portion; 60: glass substrate; 61: array substrate; 62: encapsulation layer; 63: cutting tool.

### DESCRIPTION OF EMBODIMENTS

The following describes the technical solutions in the embodiments of this application with reference to the accompanying drawings in the embodiments of this application. It is clearly that the described embodiments are merely a part rather than all of the embodiments of this application.

The following terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the description of this application, unless otherwise stated, "a plurality of" means two or more than two.

In addition, in this application, orientation terms such as "upper", "lower", "left", and "right" may be defined by, but are not limited to, orientations of components schematically placed in the accompanying drawings. It should be understood that these orientation terms may be relative concepts, and are used for description and clarification of "relative", and may change correspondingly according to a change in a placement orientation of a component drawing in the drawings.

In this application, unless otherwise expressly specified and limited, the term "connection" should be understood in a broad sense. For example, "connection" may be a fixed connection, a detachable connection or an integral connection; and may be a direct connection or an indirect connection by using an intermediate medium. In addition, the term "coupled" may be a manner of implementing an electrical connection for signal transmission.

An embodiment of this application provides a display terminal. The display terminal may be a product having a display interface, such as a mobile phone, a monitor, a tablet computer, or an in-vehicle computer, or a wearable smart display product, such as a smart watch or a smart band. A specific form of the display terminal is not specially limited in this embodiment of this application.

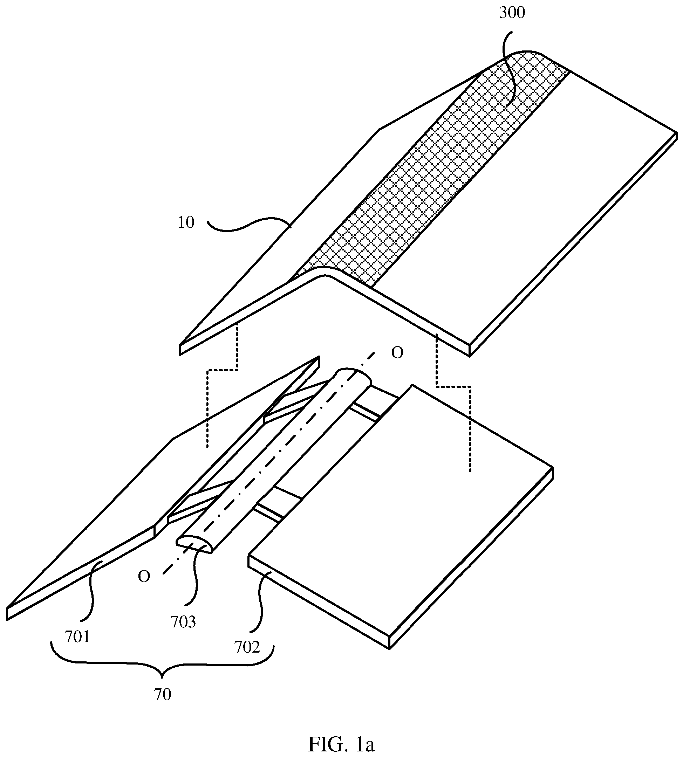

As shown in FIG. 1a, the display terminal 01 may include a flexible display screen 10 and a support component 70 configured to support the flexible display screen 10. The support component 70 includes a first housing 701, a second housing 702, and a rotating shaft 703. The rotating shaft 703 is located between the first housing 701 and the second housing 702. The first housing 701 and the second housing 702 may be connected by rotating the rotating shaft 703.

Based on this, a back surface of the flexible display screen 10 (that is, a surface of the flexible display screen 10 facing the support component 70) is connected to the first housing 701, the second housing 702, and the rotating shaft 703. A part that is of the flexible display screen 10 and that is connected to the rotating shaft 703 is used as a first bent portion 300. In this case, when the first housing 701 and the second housing 702 move relative to each other by using the rotating shaft 703, the first bent portion 300 may bend in a direction of an axis O-O of the rotating shaft 703, to fold in half a part that is of the flexible display screen 10 and that is separately connected to the first housing 701 and the second housing 702, to bend the flexible display screen 10.

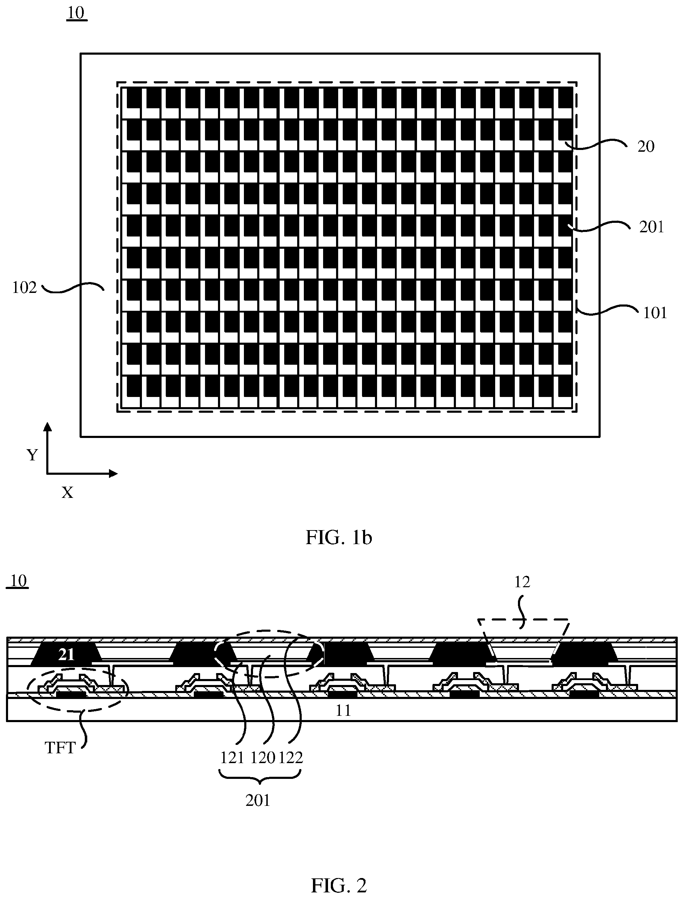

In addition, as shown in FIG. 1b, the flexible display screen 10 has a luminous area 101 and a non-luminous area 102 that is disposed on a periphery. A plurality of sub pixels (sub pixel) 20 arranged in a matrix form are disposed in the luminous area 101 of the flexible display screen 10.

For ease of description, in this application, a line of sub pixels 20 arranged in a first direction Y is referred to as a column of sub pixels, and a line of sub pixels 20 arranged in a second direction X is referred to as a row of sub pixels. The first direction Y and the second direction X are disposed perpendicular to each other. A light-emitting device, for example, an OLED device 201, is disposed in the sub pixel 20.

The OLED device 201 is manufactured on a flexible substrate 11 shown in FIG. 2. A material made into the flexible substrate 11 may include polyethylene terephthalate (polyethylene terephthalate, PET).

It should be noted that the flexible display screen 10 may be an active-matrix organic light-emitting diode (active matrix driving OLED, AMOLED) display screen. Compared with a passive-matrix organic light-emitting diode (passive matrix driving OLED, PMOLED) display screen, the AMOLED flexible display screen does not need to provide a large transient current for each light-emitting device 102, and therefore is more power-saving, and is more suitable for being applied to a large-size and high-resolution display terminal.

In addition, the OLED device 201 is self-luminous, and the OLED device 201 has an organic light-emitting layer 120, and a first electrode 121 and a second electrode 122 located on two sides of the organic light-emitting layer 120, as shown in FIG. 2. For ease of description, in this embodiment of this application, the first electrode 121 is an anode (anodic, a) of the OLED device 201, and the second electrode 122 is a cathode (cathode, c) of the OLED device 201.

In some embodiments of this application, a material made into the first electrode 121 may be a transparent conductive material, for example, indium tin oxide (indium tin oxide, ITO) or indium zinc oxide (indium zinc oxide, IZO). A material made into the second electrode 122 may be a metal material, for example, aluminum (Al) or manganese (Mg). In this case, light transmittance of the first electrode 121 is relatively high, and light transmittance of the second electrode 122 is relatively low. Therefore, light emitted by the flexible display screen 10 is emitted from a side on which the first electrode 121 is located. The flexible display screen 10 may be a bottom-luminous display screen.

On the contrary, when the material made into the first electrode 121 is the metal material, and the material made into the second electrode 122 is the transparent conductive material, light emitted by the flexible display screen 10 is emitted from a side on which the second electrode 122 is located. The flexible display screen 10 may be a top-luminous display screen.

Based on this, a light emitting principle of the OLED device 201 is that, after a voltage is applied to the first electrode 121 and the second electrode 122 on the two sides of the organic light-emitting layer 120, carriers in the first electrode 121 and the second electrode 122 meet and excite photons in the organic light-emitting layer 120, so that the organic light-emitting layer 120 emits light. In this case, the OLED device 201 emits light, and the flexible display screen 10 having a plurality of OLED devices 201 displays a picture.

The cathode c, that is, the second electrode 122, of the OLED device 201 in each sub pixel 20 generally receives a same voltage, for example, a common ground terminal voltage ELVSS. Therefore, as shown in FIG. 2, second electrodes 122 of OLED devices 201 located in different sub pixels 20 may be electrically connected and integrated to form a cathode layer. The cathode layer covers organic light-emitting layers 120 of all the OLED devices 201.

In addition, in a process of displaying an image by the flexible display screen 10, colors or brightness of light emitted by different sub pixels 20 may be different. In this case, first electrodes 121 in different sub pixels 20 as well as organic light-emitting layers 120 need to be isolated, to independently control a single OLED device 201.

In this case, as shown in FIG. 2, the flexible display screen 10 further includes a pixel define layer (pixel define layer, PDL) 21. The pixel define layer 21 has a plurality of recesses 12, and a bottom of one recess 12 exposes one first electrode 121. In this way, a plurality of first electrodes 121 may be disposed on the flexible substrate 11 at intervals.

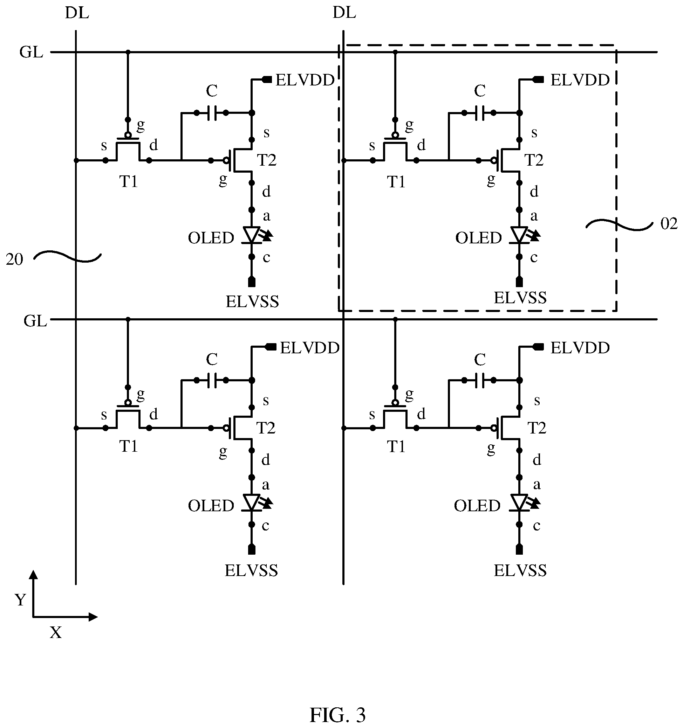

To supply power to each first electrode 121 separately, as shown in FIG. 3, a pixel drive circuit 02 is further disposed in each sub pixel 20. The pixel drive circuit 02 includes a plurality of transistors, for example, thin film transistors (thin film transistor, TFT), and at least one capacitor.

In FIG. 3, an example in which the pixel drive circuit 02 includes one OLED device, two transistors T1 and T2, and one capacitor C is used for description. A gate of the transistor T1 is coupled to a gate line (gate line, GL), a first electrode, for example, a source (source, s), is coupled to a data line (data line, DL), and a second electrode, for example, a drain (drain, d), is coupled to a gate g of the transistor T2.

A first electrode, for example, a source s, of the transistor T2 is coupled to a voltage end ELVDD, and a second electrode, for example, a drain d, is coupled to an anode a of the OLED device. A cathode c of the OLED device is coupled to a voltage end ELVSS. After the transistor T1 is controlled to be turned on by providing a gate drive signal to the gate line GL, a data voltage Vdata may be transmitted to the gate (gate, g) of the transistor T2 by using the data line DL, so that the transistor T2 serves as a drive transistor to drive the OLED device to emit light.

Each gate line GL is coupled to gates g of transistors T1 in sub pixels 20 located in the same row as the gate line GL (in the second direction X). Each data line is coupled to sources s of transistors T1 in sub pixels 20 located in the same column as the data line (in the first direction Y). Therefore, after the gate drive signal is input to gate lines GL row by row, all the data lines DL may provide the data voltage Vdata for sources s of transistors T1 in a same row of sub pixels 20.

It should be noted that the foregoing description is provided by using an example in which a part that is in the pixel circuit 02 and that is configured to drive the OLED device to emit light includes two transistors and one capacitor. To enable the pixel circuit 02 to have more functions, for example, a reset function and a threshold voltage compensation function, another transistor may be further added to the pixel circuit 02. A structure of the pixel circuit 02 is not limited in this application.

It can be learned from the above that an independent voltage may be provided for a first electrode 121 of each OLED device by using pixel circuits 02 located in different sub pixels 20, to separately control brightness of light emitted by the OLED device. In addition, organic light-emitting layers 120 of different materials may be formed in different recesses 12 through evaporation, to independently control a color of light emitted by a single OLED device.

For example, when one pixel (pixel) includes three adjacent sub pixels 20 shown in FIG. 2, OLED devices 201 in the three adjacent sub pixels 20 may respectively emit red (red, R), green (green, G), and blue (blue, B) light.

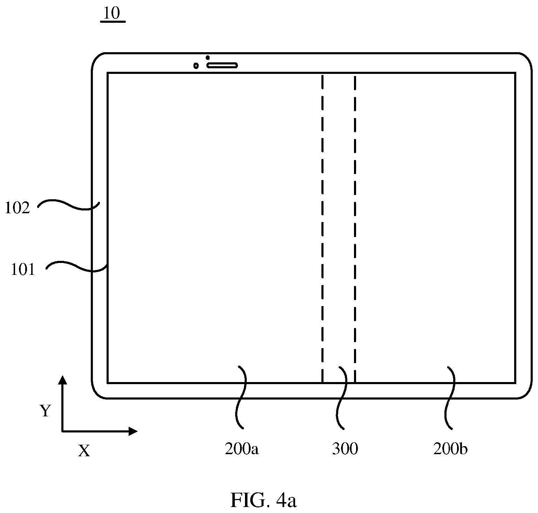

Based on this, it can be learned from the above that the part that is of the flexible display screen 10 and that is connected to the rotating shaft 703 is the first bent portion 300. When the first bent portion 300 is bent in the direction (parallel to the first direction Y shown in 4a) of the axis O-O of the rotating shaft 703, the part that is of the flexible display screen 10 and that is separately connected to the first housing 701 and the second housing 702 may be folded in half. For ease of description, a part that is of the flexible display screen 10 and that is connected to the first housing 701 is referred to as a first display portion 200a, and a part that is of the flexible display screen 10 and that is connected to the second housing 702 is referred to as a second display portion 200b, as shown in FIG. 4a.

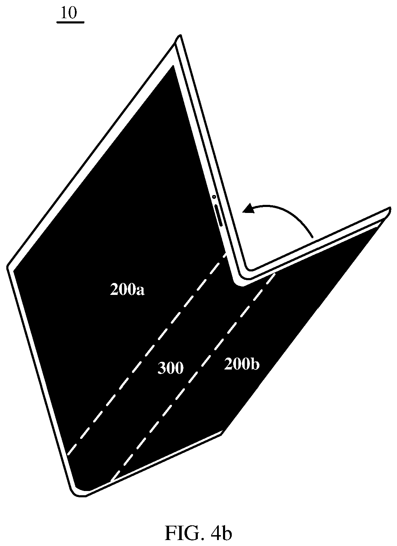

Because the rotating shaft 703 is located between the first housing 701 and the second housing 702, as shown in FIG. 4b, the first bent portion 300 is located between the first display portion 200a and the second display portion 200b. The sub pixels are disposed in the first display portion 200a and the second display portion 200b, and the first display portion 200a and the second display portion 200b may be independently controlled to display pictures.

To simplify a manufacturing process, when pixel circuits 02 in the sub pixels 20 in the first display portion 200a and the second display portion 200b are manufactured, the pixel circuits 02 may also be formed in the first bent portion 300. Based on this, when the first bent portion 300 does not need to perform display, in some embodiments of this application, a data line DL in the first bent portion 300 may be disconnected from a drive circuit configured to provide the data voltage Vdata for the data line DL.

Alternatively, in some other embodiments of this application, when the data line DL in the first bent portion 300 is coupled to the drive circuit configured to provide the data voltage Vdata for the data line DL, the first bent portion 300 may be controlled to display a black screen or a pattern consistent with a background image displayed on the display portions.

It should be noted that, a manner in which two adjacent display portions, for example, the first display portion 200a and the second display portion 200b, are folded in half by using the first bent portion 300 is not limited in this application. For example, when the first display portion 200a and the second display portion 200b are folded in half, a display surface of the first display portion 200a may face a display surface of the second display portion 200b. In this case, the flexible display screen 10 is an inward-folded display screen. Alternatively, a back surface (that is, a non-display surface) of the first display portion 200a may face a back surface of the second display portion 200b. In this case, the flexible display screen 10 is an outward-folded display screen.

FIG. 4a is described by using an example in which the parts on the two sides of the first bent portion 300 in the flexible display screen 10 are referred to as the first display portion 200a and the second display portion 200b based on the structure of the support component 70.

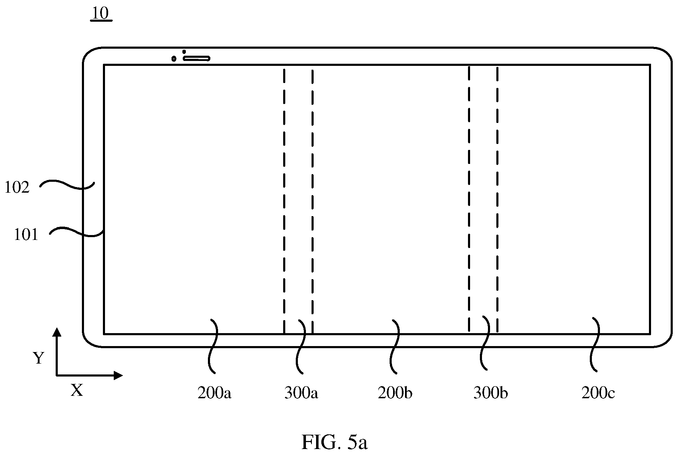

In some other embodiments of this application, when a rotating shaft and a housing are further added to the support component 70, a part that is of the flexible display screen 10 and that is connected to the added rotating shaft may be used as a first bent portion 300b shown in FIG. 5a. In this case, parts on two sides of the first bent portion 300b in the flexible display screen 10 may be referred to as the second display portion 200b and a third display portion 200c.

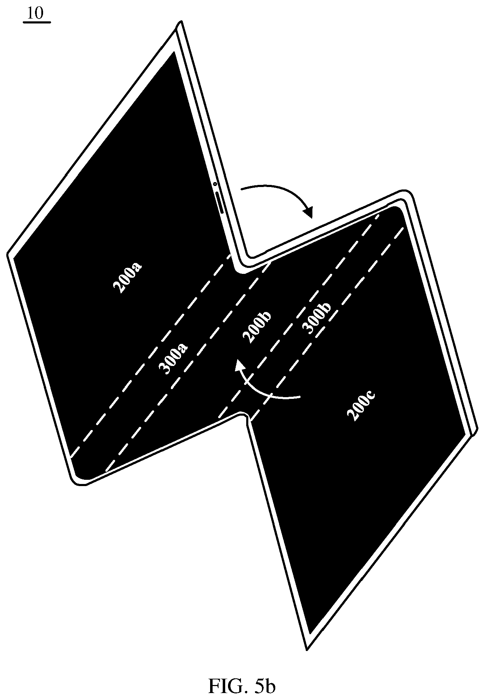

As shown in FIG. 5b, the first bent portion 300a is configured to bend in the first direction Y, to fold in half the first display portion 200a and the second display portion 200b. For example, the back surface of the first display portion 200a may face the back surface of the second display portion 200b. The first bent portion 300b is configured to bend in the first direction Y, to fold in half the second display portion 200b and the display portion 200c. For example, the display surface of the second display portion 200b may face a display surface of the display portion 200c. In this case, the flexible display screen 10 is an inward and outward-folded display screen.

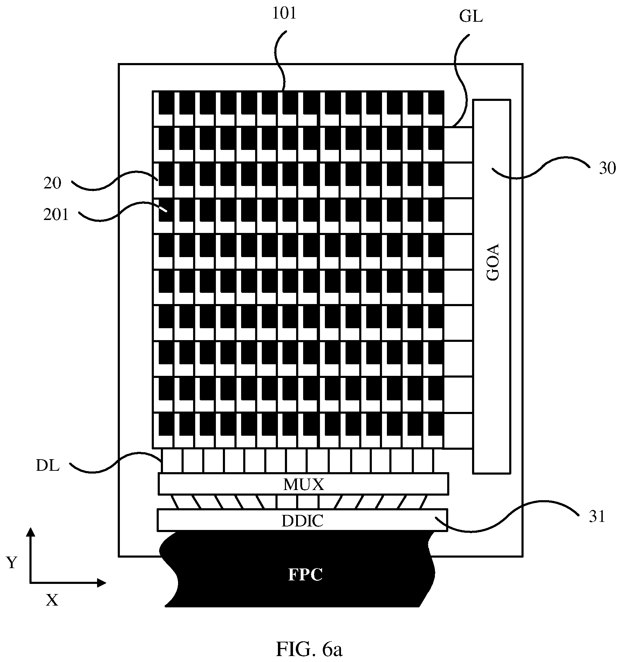

In addition, the display terminal further includes a gate drive circuit 30 shown in FIG. 6a. The gate drive circuit 30 is disposed in the non-luminous area 102 of the flexible display screen 10. The non-luminous area 102 is disposed on the periphery of the luminous area 101 of the flexible display screen 10.

The gate drive circuit 30 is coupled to each gate line GL, and configured to provide a gate drive signal for the gate line GL. In some embodiments of this application, to reduce a border size of the flexible display screen 10, a gate driver on array (gate driver on array, GOA) technology may be used to integrate a TFT mainly for forming the gate drive circuit 30 into the flexible substrate 11 of the flexible display screen 10. In this way, when TFTs in the pixel circuits 02 are manufactured on the flexible substrate 11, preparation of the TFT in the gate drive circuit 30 may be completed.

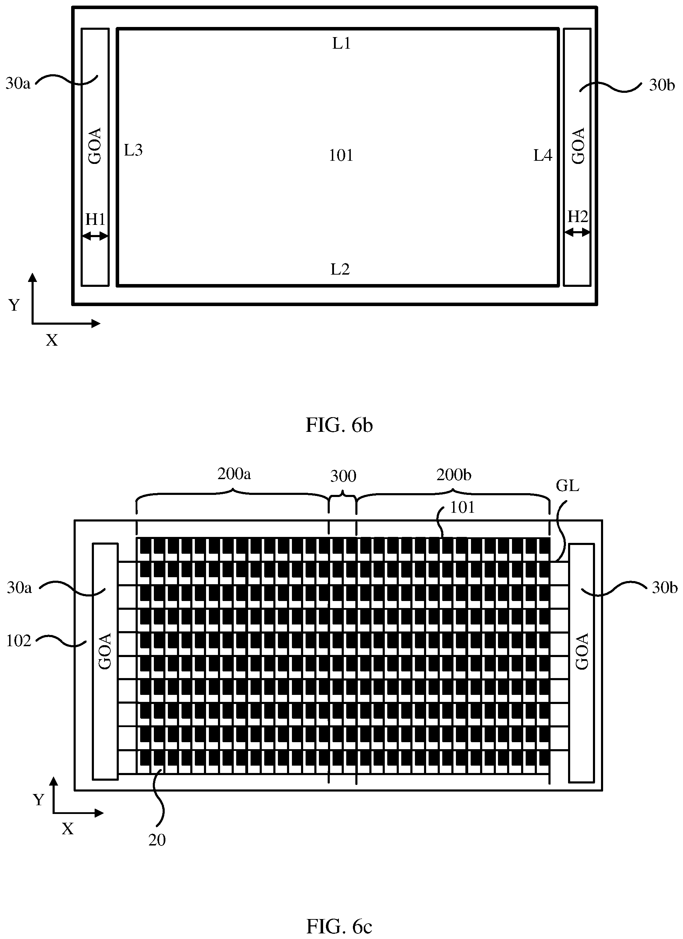

In some embodiments of this application, when the luminous area 101 of the flexible display screen 10 is a rectangle, when a length of a long side of the luminous area 101 differs greatly from a length of a short side, for example, as shown in FIG. 6b, a length of a long side (for example, a first long side L1 and a second long side L2 disposed opposite to each other) of the luminous area 101 in the second direction X differs greatly from a length of a short side (for example, a first short side L3 and a second short side L4 disposed opposite to each other) in the first direction Y, the gate drive circuit may include a first gate drive circuit 30a and a second gate drive circuit 30b located on two sides of the luminous area 101.

The first gate drive circuit 30a is disposed on a side on which the first short side L3 of the luminous area 101 is located. The second gate drive circuit 30b is disposed on a side on which the second short side L4 of the luminous area 101 is located. As shown in FIG. 6c, the first gate drive circuit 30a is coupled to a gate line GL, and configured to provide a gate drive signal for at least a part of the luminous area 101. The second gate drive circuit 30b is coupled to a gate line GL, and configured to provide a gate drive signal for at least a part of the luminous area 101.

It should be noted that, the description that the first gate drive circuit 30a is configured to provide a gate drive signal for at least a part of the luminous area 101 and the second gate drive circuit 30b provides a gate drive signal for at least a part of the luminous area 101 means that in some embodiments of this application, the first gate drive circuit 30a may be coupled to a gate line GL of an even-number row to provide a gate drive signal for sub pixels 20 of the even-number row, and the second gate drive circuit 30b may be coupled to a gate line GL of an odd-number row to provide a gate drive signal for sub pixels 20 of the odd-number row.

Alternatively, in some other embodiments of this application, when the first gate drive circuit 30a is coupled to each row of gate line GL corresponding to a position of the first display portion 200a in the luminous area 101 shown in FIG. 6c, and the second gate drive circuit 30b is coupled to each row of gate line GL corresponding to a position of the second display portion 200b in the luminous area 101, the first gate drive circuit 30a may provide a gate drive signal for each row of sub pixels 20 in the first display portion 200a, and the second gate drive circuit 30b may provide a gate drive signal for each row of sub pixels 20 in the second display portion 200b.

Alternatively, in some other embodiments of this application, when the first gate drive circuit 30a is coupled to each row of gate line GL in the luminous area 101 shown in FIG. 6c, and the second gate drive circuit 30b is coupled to each row of gate line GL in the luminous area 101, the first gate drive circuit 30a may provide a gate drive signal for each row of sub pixels 20 in the luminous area 101 from left to right, and the second gate drive circuit 30b may provide a gate drive signal for each row of sub pixels 20 in the luminous area 101 from right to left.

In addition, it can be learned from the above that the first gate drive circuit 30a and the second gate drive circuit 30b may be integrated on the flexible substrate 11 by using the GOA technology. Therefore, compared with a solution of separately coupling to gate drive chips, border widths of the flexible display screen 10 on left and right sides can be reduced, thereby implementing a narrow-border design.

Based on this, in the second direction X, a width H1 of the first gate drive circuit 30a may be the same as a width H2 of the second gate drive circuit 30b. In this way, the border widths of the flexible display screen 10 on the left and right sides may also be the same, so that the left and right sides of the luminous area 101 of the flexible display screen 10 are symmetric, thereby improving overall aesthetics of the screen.

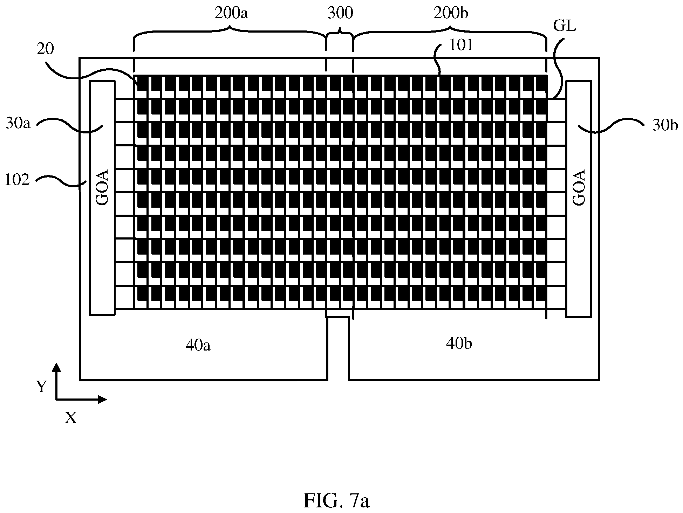

In addition, when the display terminal further includes a drive chip, for example, a display driver integrated circuit (display driver integrated circuit, DDIC), to enable the data lines DL to couple to the drive chip configured to provide the data voltage Vdata, where the coupling may also be referred to as bonding (banding), as shown in FIG. 7a, the flexible display screen 10 further includes a plurality of first peripheral portions 40a and second peripheral portions 40b located in the non-luminous area 102. The first peripheral portion 40a and the second peripheral portion 40b are disposed side by side on a same side of the luminous area 101. A part that is of the first peripheral portion 40a and that is bent to the back surface of the flexible display screen 10 faces the first housing 701, and the part may be fixed to the back surface of the first display portion 200a in the flexible display screen 10 by using an adhesive layer. In addition, a part that is of the second peripheral portion 40b and that is bent to the back surface of the flexible display screen 10 faces the second housing 702, and the part may be fixed to the back surface of the second display portion 200b in the flexible display screen 10 by using an adhesive layer.

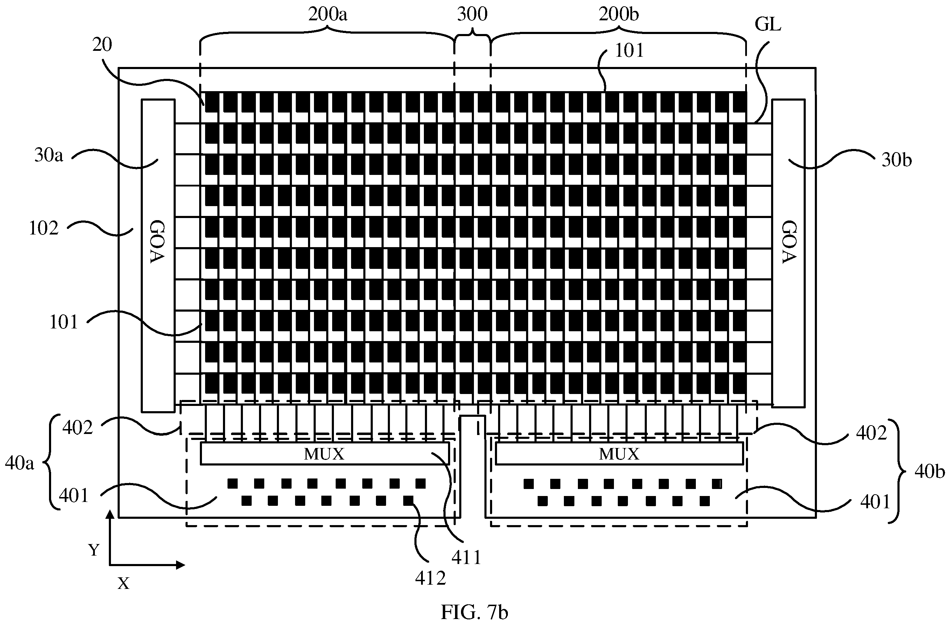

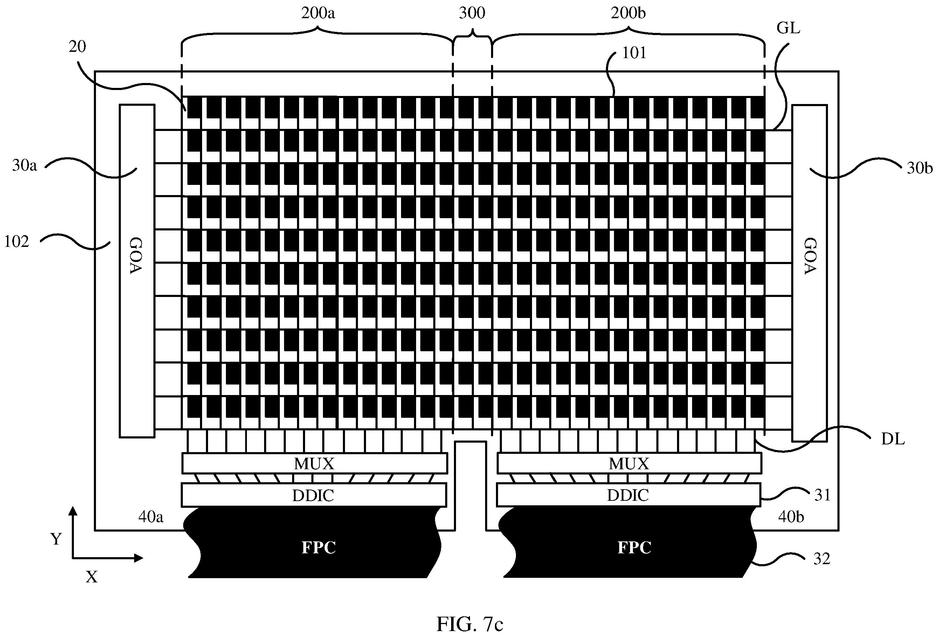

In some embodiments of this application, as shown in FIG. 7b, either of the first peripheral portion 40a and the second peripheral portion 40b includes a multiplexer (multiplexer, MUX) 411 and a plurality of pads (pad) 412 coupled to the MUX 411. The MUX 411 is configured to couple to the data lines DL in the flexible display screen 10, and the pads 412 are configured to couple to a drive chip 31 shown in FIG. 7c.

After the peripheral portion is bent in a direction (that is, the second direction X) perpendicular to the axis O-O of the rotating shaft 703, the MUX 411 and the pads 412 are disposed on the back surface of the flexible display screen 10. Because a part on which the pads 412 are disposed on the peripheral portion is configured to couple to the external drive chip 31, in this application, the part on which the pad 412 is disposed on the peripheral portion may be referred to as an outer lead bonding (outer lead bonding, OLB) 401.

In addition, when the display terminal further includes a flexible printed circuit (flexible printed circuit, FPC) 32 shown in FIG. 7c, some pads 412 on the OLB 401 are further configured to couple to the FPC 32. In this case, the flexible printed circuit FPC is coupled to the drive chip 31, and the drive chip 31 is coupled to the data lines DL by using the MUX 411, and configured to provide the data voltage for the data lines DL.

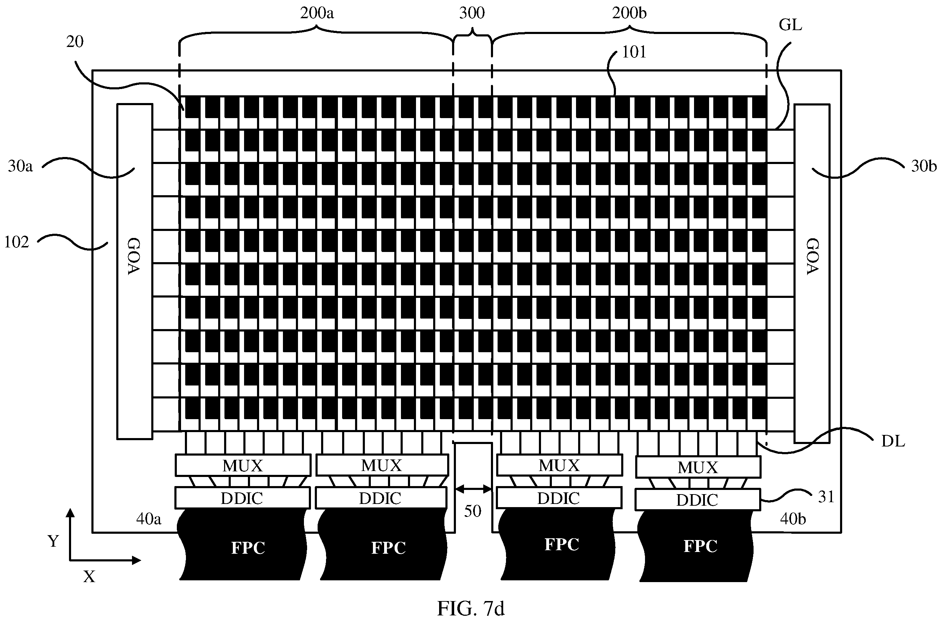

FIG. 7c is described by using an example in which one MUX 411, one drive chip 31, and one FPC 32 are disposed on either of the first peripheral portion 40a and the second peripheral portion 40b. In some other embodiments of this application, when a quantity of sub pixels 20 in one row (in the second direction X) is relatively large, and a quantity of data voltage output ends used by one drive chip 31 to output the data voltage Vdata cannot meet a quantity requirement of the data lines DL in the flexible display screen 10, as shown in FIG. 7d, at least two drive units may be disposed on either of the first peripheral portion 40a and the second peripheral portion 40b, and each drive unit includes one MUX 411, one drive chip 31, and one FPC 32 that are coupled.

Based on this, the display terminal further includes a printed circuit board (printed circuit board, PCB) disposed and a system on chip (System on Chip, SoC) installed on the PCB. In this case, an application processor (application processor, AP) may be disposed in the SoC. The drive chip 31 shown in FIG. 7c is coupled to the SoC by using the FPC 32.

In this way, display data that is output by the SoC may be converted into a data voltage Vdata after passing through the drive chip 31. In a time period, the MUX 411 may select, based on a requirement, only some data lines DL to receive data voltages Vdata output by data voltage output ends of the drive chip 31. Next, pixel circuits 02 generate, by using data voltages Vdata on the data lines DL, drive currents I matching the data voltages Vdata, to drive OLED devices 201 in sub pixels 20 to emit light.

It should be noted that, when the drive chip 31 is a DDIC, the drive chip 31 may be further coupled to the gate drive circuit, for example, the first gate drive circuit 30a and the second gate drive circuit 30b, so that the drive chip 31 can control a time sequence of gate drive signals output by the gate drive circuit 30.

In addition, as shown in FIG. 7b, in either of the first peripheral portion 40a and the second peripheral portion 40b, a part located between the OLB 401 and the luminous area 101 is configured to enable the peripheral portion to bend. For ease of description, the part may be referred to as a second bent portion 402 of the peripheral portion.

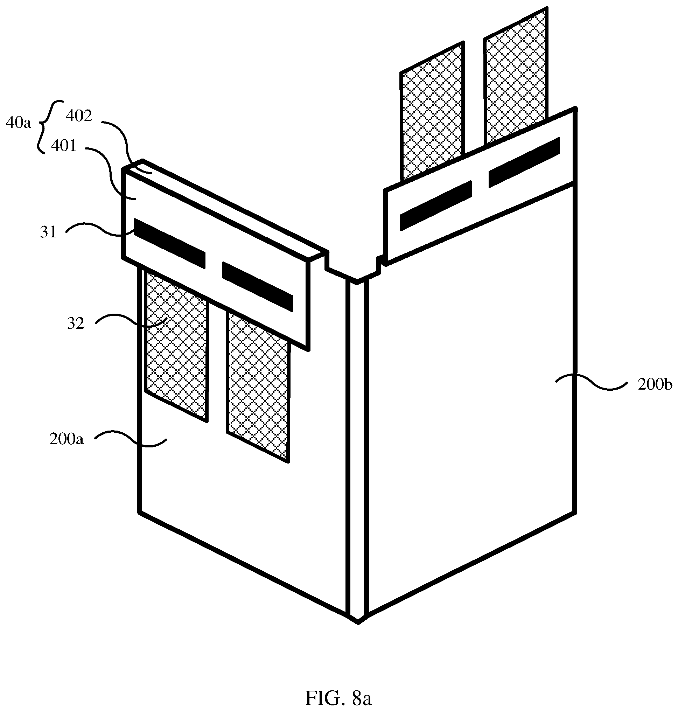

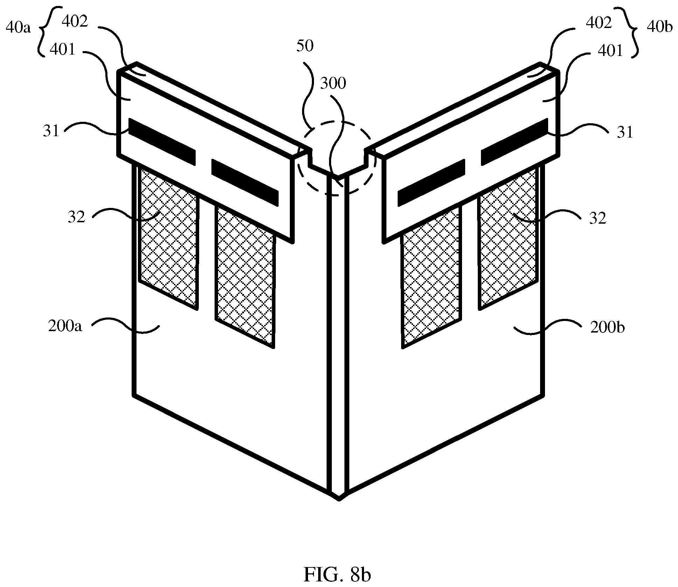

The second bent portion 402 in the first peripheral portion 40a is configured to bend in the second direction X, so that the OLB 401 in the first peripheral portion 40a is bent to the back surface of the first display portion 200a of the flexible display screen 10, as shown in FIG. 8a. In addition, as shown in FIG. 8b, the second bent portion 402 in the second peripheral portion 40b is configured to bend in the second direction, to bend the OLB 401 in the second peripheral portion 40b to the back surface of the second display portion 200b of the flexible display screen 10. In this way, a border size on the side on which the first peripheral portion 40a and the second peripheral portion 40b are located in the flexible display screen 10 can be reduced.

Based on this, as shown in FIG. 7b, when the luminous area 101 is a rectangle shown in FIG. 6b, the first peripheral portion 40a and the second peripheral portion 40b may be located on a long side of the luminous area 101, for example, a side on which the second long side L2 is located. In this way, each data line DL coupled to the drive chip 31 on the peripheral portion is disposed in the first direction Y, that is, on a short side (for example, the first short side L3 and the second short side L4 in FIG. 6b) of the luminous area 101, as shown in FIG. 7d. Compared with a solution in which the data line DL is disposed in the second direction X, that is, the long side of the luminous area 101, a routing length of the data line DL can be greatly reduced, thereby reducing a signal transmission loss of the data line DL and a load resistance RC, improving a driving capability of the drive chip 31, and mitigating uneven display caused by a signal delay in a signal transmission process of the data line DL.

Based on this, the flexible display screen 10 further includes a first notch 50 shown in FIG. 7d. The first notch 50 is in the non-luminous area 102, and disposed on a side of the first bent portion 300. In other words, one first notch 50 is correspondingly disposed below a position of one first bent portion 300. In addition, the first notch 50 is further located between the first peripheral portion 40a and the second peripheral portion 40b. The first notch 50 is configured to separate the first peripheral portion 40a from the second peripheral portion 40b.

In this way, by disposing the first notch 50, a part that is in the non-luminous area 102 of the flexible display screen 10 and that is configured to couple to the drive chip 31 and the FPC 32, that is, a part on which the OLB is located, may be segmented to form a plurality of peripheral portions, for example, the first peripheral portion 40a and the second peripheral portion 40b. By bending each peripheral portion separately (pad bending), a length (that is, a size in the second direction X) of a bent part in the non-luminous area 102 can be reduced, to improve a bending yield rate.

In addition, because the first notch 50 is located on a side of the first bent portion 300 and disposed between the first peripheral portion 40a and the second peripheral portion 40b, when the first bent portion 300 is bent, no stress is generated at a position of the first notch 50. In this way, a probability that a stress concentration problem occurs because the non-luminous area 102 of the flexible display screen 10 is folded a plurality of times can be reduced.

In addition, as shown in FIG. 8b, the second bent portion 402 of the first peripheral portion 40a is bent, to turn the OLB 401 of the first peripheral portion 40a to the back surface of the first display portion 200a of the flexible display screen 10, and the second bent portion 402 of the second peripheral portion 40b is bent, to turn the OLB 401b of the second peripheral portion 40b to the back surface of the second display portion 200b of the flexible display screen 10. Then, the first display portion 200a and the second display portion 200b are folded in half by using the first bent portion 300. In this case, in a process of bending the first bent portion 300, as the first notch 50 separates the first peripheral portion 40a from the second peripheral portion 40b, a probability that a phenomenon such as pulling or wrinkling occurs on the OLB 401 of the first peripheral portion 40a and the OLB 401 of the second peripheral portion 40b is reduced.

Based on this, in some embodiments of this application, in the second direction X shown in FIG. 7d, an opening width of the first notch 50 is greater than a width of the first bent portion 300. In this way, after the OLB 401 of the first peripheral portion 40a and the OLB 401 of the second peripheral portion 40b are respectively bent to the back surface of the first display portion 200a and the back surface of the second display portion 200b, when the first display portion 200a and the second display portion 200b are folded in half by using the first bent portion 300, a position of the first bent portion 300 does not crush the OLB 401 of the first peripheral portion 40a or the OLB 401 of the second peripheral portion 40b, thereby reducing a probability of a phenomenon such as pulling or wrinkling.

It should be noted that, a manner of disposing the first notch 50 between the first peripheral portion 40a and the second peripheral portion 40b is described above by using an example in which the flexible display screen 10 has one first bent portion 300 and two display portions, namely, the first display portion 200a and the second display portion 200b, shown in FIG. 8b that are located on two sides of the first bent portion 300 and that can independently perform display.

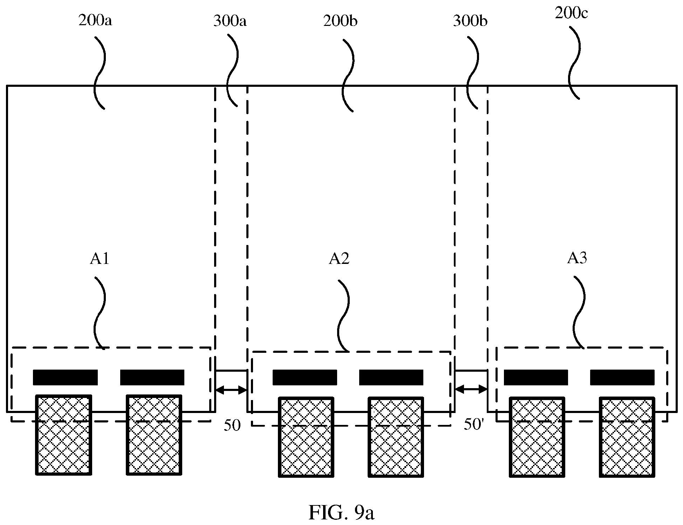

In some other embodiments of this application, as shown in FIG. 9a, when the flexible display screen 10 includes two first bent portions, for example, the first bent portion 300a and the first bent portion 300b, as described above, three display portions that can independent perform display, namely, the first display portion 200a, the second display portion 200b, and the third display portion 200c, may be disposed in the flexible display screen 10. Based on this, the flexible display screen 10 may include three peripheral portions: a peripheral portion A, a peripheral portion B, and a peripheral portion C. Similarly, it can be learned that one first notch may be disposed between two adjacent peripheral portions. For example, a first notch 50 is disposed between the peripheral portion A and the peripheral portion B, and a first notch 50' is disposed between the peripheral portion B and the peripheral portion C.

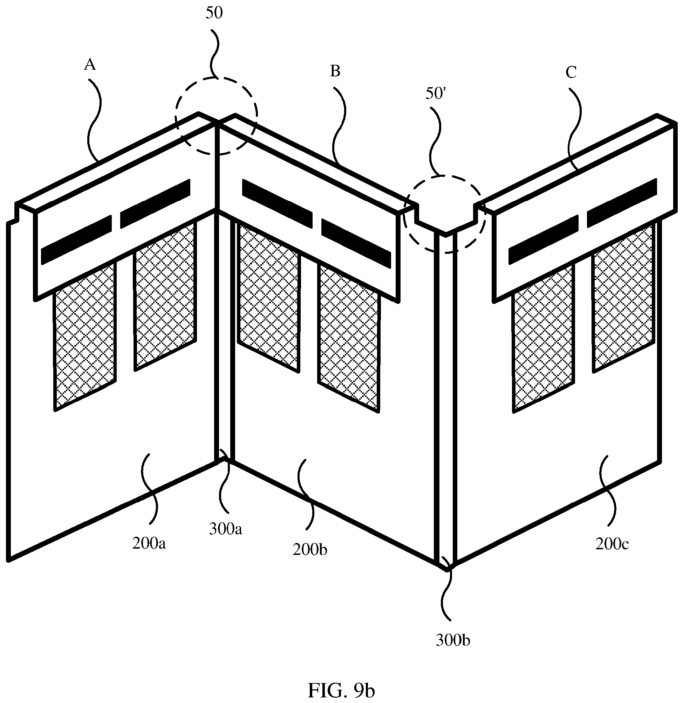

In this case, for the peripheral portion A and the peripheral portion B, the peripheral portion A may serve as the first peripheral portion 40a, and the peripheral portion B may serve as the second peripheral portion 40b. As shown in FIG. 9b, the peripheral portion A and the peripheral portion B are bent separately, so that the peripheral portion A can be bent to the back surface of the first display portion 200a, and the peripheral portion B can be bent to the back surface of the second display portion 200b. In addition, for the peripheral portion B and the peripheral portion C, the peripheral portion C may serve as the first peripheral portion 40a, and the peripheral portion B may serve as the second peripheral portion 40b. As shown in FIG. 9b, the peripheral portion C and the peripheral portion B are bent separately, so that the peripheral portion C can be bent to a back surface of the third display portion 200c, and the peripheral portion B can be bent to the back surface of the second display portion 200b.

For ease of description, the following descriptions are all provided by using an example in which the flexible display screen 10 has two display portions shown in FIG. 8b, namely, the first display portion 200a and the second display portion 200b.

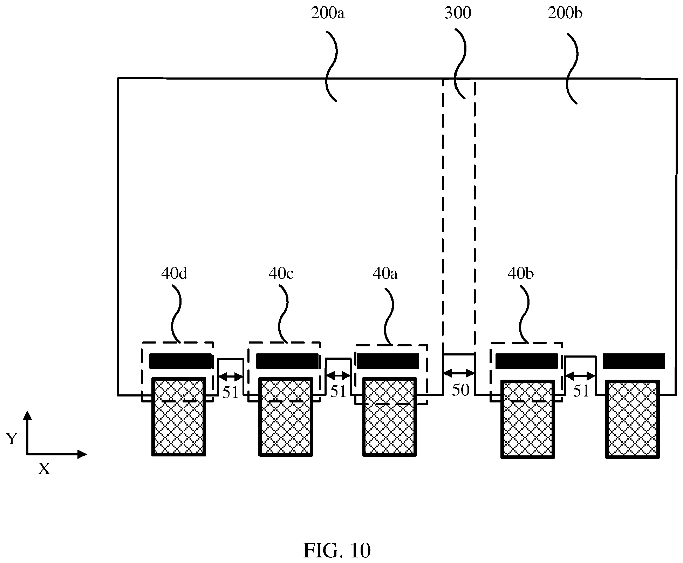

In some other embodiments of this application, as shown in FIG. 10, the flexible display screen 10 may further include a third peripheral portion 40c, a fourth peripheral portion 40d, and a second notch 51. The second notch 51 is located between the third peripheral portion 40c and the fourth peripheral portion 40d. The third peripheral portion 40c, the fourth peripheral portion 40d, and the first peripheral portion 40a are located on the same side of the non-luminous area 102. Parts that are of the third peripheral portion 40c and the fourth peripheral portion 40d and that are bent to the first display portion 200a in the flexible display screen 10 both face the first housing 701.

In this case, the second notch 51 may be configured to separate the third peripheral portion 40c and the fourth peripheral portion 40d that can be bent to a back surface of a same display portion, for example, the first display portion 200a. In this way, the length of the bent part of the non-luminous area 102 can be further reduced, to improve a bending yield rate.

In some embodiments of this application, to simplify a manufacturing process, shapes of the first notch 50 and the second notch 51 may be the same. In addition, in the second direction X shown in FIG. 10, an opening width of the first notch 50 is the same as an opening width of the second notch 51.

Alternatively, in some other embodiments, the shapes of the first notch 50 and the second notch 51 may be different, and in the second direction X shown in FIG. 10, the opening width of the first notch 50 and the opening width of the second notch 51 may be different. This is not limited in this application.

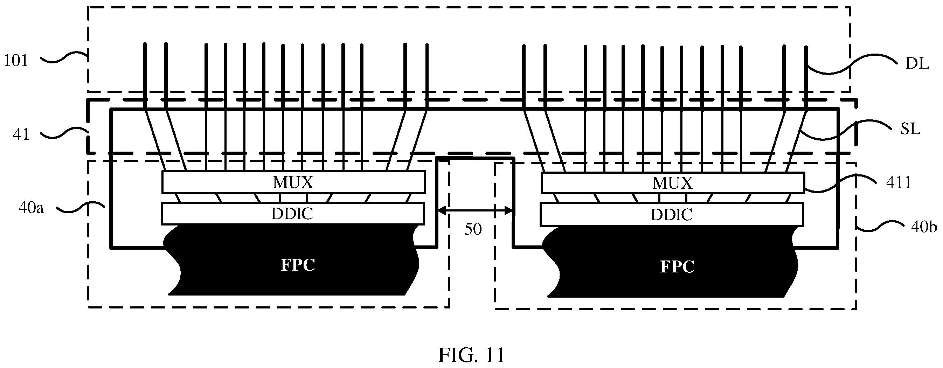

In addition, when the flexible display screen 10 includes the first notch 50, to prevent data lines DL in the flexible display screen 10 from being affected by the first notch 50 when coupling to the MUXs 411 on the first peripheral portion 40a and the second peripheral portion 40b, as shown in FIG. 11, the flexible display screen 10 further includes a fan-out portion 41. The fan-out portion 41 is located between the luminous area 101 and the peripheral portions.

In addition, the fan-out portion 41 includes a plurality of fan-out leads SL. A first end of the fan-out lead SL is coupled to the MUX 411, and a second end is coupled to a data line DL. A fan-out lead SL close to the first notch 50 is disposed bypassing an edge of the first notch 50. For example, the fan-out lead SL close to the first notch 50 may be disposed obliquely to bypass the edge of the first notch 50.

Based on this, it can be learned from the above that, when the first bent portion 300 needs to perform display, a data line DL in the first bent portion 300 may be coupled, by using a fan-out lead SL located in the fan-out portion 41, to the DDIC configured to provide the data voltage Vdata for the data line DL. One first notch 50 is correspondingly disposed below a position of one first bent portion 300. Therefore, the fan-out lead SL that is in the fan-out portion 41 and that is configured to couple the data line DL in the first bent portion 300 and the DDIC may be disposed obliquely to bypass the edge of the first notch 50.

Similarly, when the flexible display screen 10 includes the second notch 51, to prevent a data line DL in the flexible display screen 10 from being affected by the second notch 51 when coupling to a MUX 411 on a peripheral portion, in the fan-out portion 41, a fan-out lead SL close to the second notch 51 may be disposed bypassing an edge of the second notch 51.

The following uses the flexible display screen 10 shown in FIG. 7c as an example to describe a method of manufacturing the flexible display screen 10.

First, the pixel circuit 01 that is to be manufactured on the flexible substrate 11, a peripheral drive circuit (for example, the MUX 411 and the selected drive chip 31), an OLB layout, a reliability device and structure, and a position and a shape of the first notch 50 are designed.

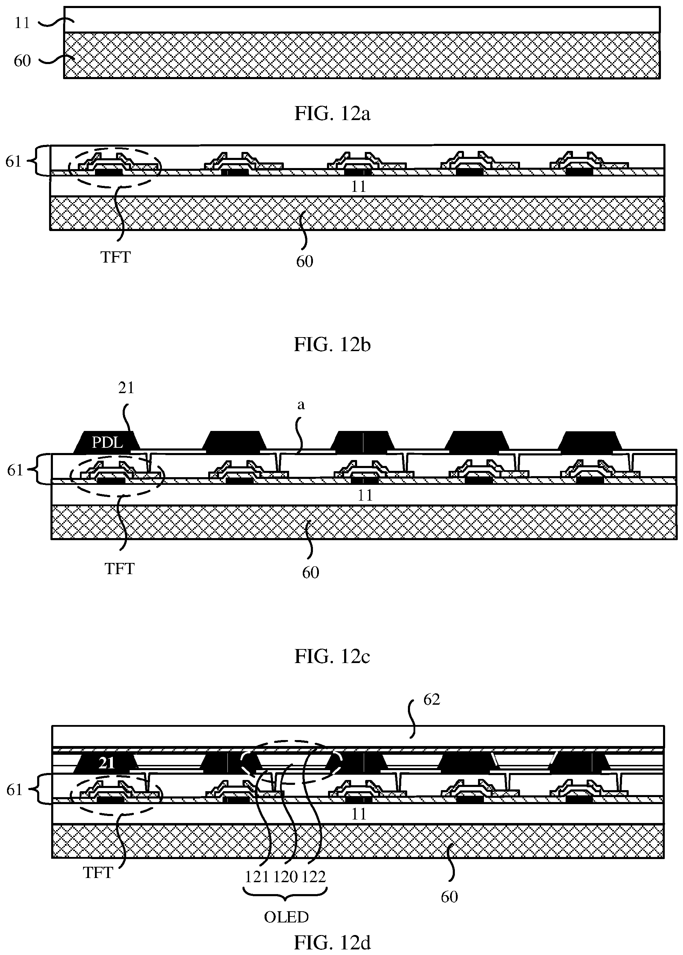

Next, a liquid polyimide (polyimide, PI) material is coated on a glass substrate 60 shown in FIG. 12a and cured at a high temperature to form the flexible substrate 11.

It should be noted that, to facilitate separation of the manufactured flexible display screen 10 from the glass substrate 60, a layer of heat release glue (not shown in the figure) may be first coated on the glass substrate 60 before the flexible substrate 11 is formed.

Next, as shown in FIG. 12b, an array substrate 61 of the flexible substrate 11 is prepared by using a pattern composition process, for example, a yellow light process (including masking, exposure, development, etching, and the like). TFTs and capacitors C in the pixel circuits 02 shown in FIG. 3 are formed on the array substrate 61.

Next, as shown in FIG. 12c, the PDL 21 is manufactured on the array substrate 61, to define the position of the OLED device in each sub pixel 20. Then, the anode a of the OLED device 201 is formed on the array substrate 61 by using a fine mask process.

Next, as shown in FIG. 12d, on the flexible substrate 11 on which the foregoing structure is formed, an organic/inorganic composite layer is deposited to form the OLED device located in each sub pixel 20. Then, an encapsulation layer 62 is formed.

Next, the manufactured substrate is cut to form the first notch 50.

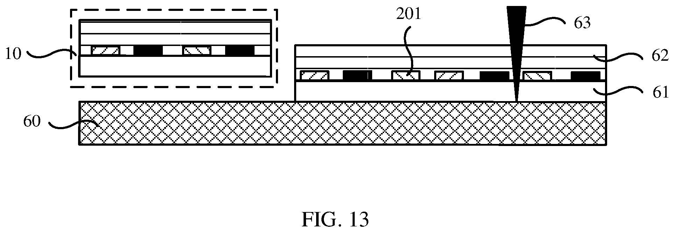

For example, the substrate formed by using the foregoing process may be cut by using a cutting tool 63 such as a laser or a knife wheel (shown in FIG. 13), to separate independent flexible display screens 10. The first notch 50 is formed at the designed position of the first notch 50 by the cutting tool 63 by using a notch (notch) processing process, a grooving process, or a slotting process. Then, the heat release glue on the glass substrate 60 is heated by using a laser to separate the flexible substrate 11 from the glass substrate 60.

Next, film layers such as a polarizer and a touchscreen are attached above the flexible display screen 10 by using a module process, and pins (pin) of the drive chip 31 and the FPC 32 are bonded to the pads 412 (shown in FIG. 7b) in the non-luminous area 102 of the flexible display screen 10 in a pin-to-pin manner by using an OLB process. Then, a reinforcing backplane is disposed on the back surface of the flexible display screen 10, and a cover covers a touch surface of the touchscreen.

Finally, the first peripheral portion 40a and the second peripheral portion 40b in the non-luminous area 102 of the flexible display screen 10 are bent to the back surface of the flexible display screen 10 by using a bending process, to complete assembly of the folded display terminal.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display terminal, comprising a support component (70) and a flexible display screen (10), wherein
the support component (70) comprises a first housing (701), a second housing (702), and a rotating shaft (703); the rotating shaft (703) is located between the first housing (701) and the second housing (702); and the first housing (701) and the second housing (702) are connected by rotating the rotating shaft (703); and
a back surface of the flexible display screen (10) is connected to the first housing (701), the second housing (702), and the rotating shaft (703); a part that is of the flexible display screen (10) and that is connected to the rotating shaft (703) is used as a first bent portion (300); and the first bent portion (300) is configured to bend along an axis of the rotating shaft (703), to fold in half a part that is of the flexible display screen (10) and that is separately connected to the first housing (701) and the second housing (702); and
the flexible display screen has a luminous area (101) and a non-luminous area (102) that is disposed on a periphery of the luminous area (101); and the flexible display screen (10) comprises:
a first peripheral portion (40a) and a second peripheral portion (40b); wherein the first peripheral portion (40a) and the second peripheral portion (40b) are in the non-luminous area (102), and disposed side by side on a same side of the luminous area (101); a part that is of the first peripheral portion (40a) and that is bent to the back surface of the flexible display screen (10) faces the first housing (701); and a part that is of the second peripheral portion (40b) and that is bent to the back surface of the flexible display screen (10) faces the second housing (702); and
a first notch (50), wherein the first notch (50) is in the non-luminous area (102), disposed on a side of the first bent portion (300), and located between the first peripheral portion (40a) and the second peripheral portion (40b); wherein the flexible display screen (10) further comprises a plurality of data lines; and **characterised in that**
each of the first peripheral portion (40a) and the second peripheral portion (40b) comprises a multiplexer (411) and a plurality of pads (412) coupled to the multiplexer (411); the multiplexer (411) is configured to couple to the data lines; and after the first peripheral portion (40a) is bent in a direction perpendicular to the axis of the rotating shaft (703), the multiplexer (411) and the pads (412) are disposed on the back surface of the flexible display screen (10); wherein the display terminal (01) further comprises a drive chip (31) coupled to the pads (412).

2. The display terminal according to claim 1, wherein the flexible display screen (10) further comprises:
a fan-out portion (41), located between the luminous area (101) and the peripheral portions, wherein
the fan-out portion (41) comprises a plurality of fan-out leads; a first end of the fan-out lead is coupled to the multiplexer (411), and a second end is coupled to the data line; and the fan-out lead close to the first notch (50) is disposed bypassing an edge of the first notch (50).

3. The display terminal according to claim 1, wherein the flexible display screen (10) further comprises a third peripheral portion (40c), a fourth peripheral portion (40d), and a second notch (51); the second notch (51) is located between the third peripheral portion (40c) and the fourth peripheral portion (40d), and the third peripheral portion (40c), the fourth peripheral portion (40d), and the first peripheral portion (40a) are located on a same side of the non-luminous area (102); and
parts that are of the third peripheral portion (40c) and the fourth peripheral portion (40d) and that are bent to the back surface of the flexible display screen (10) both face the first housing (701).

4. The display terminal according to claim 3, wherein the first notch (50) and the second notch (51) have a same shape; in a direction perpendicular to the axis of the rotating shaft (703), an opening width of the first notch (50) is the same as an opening width of the second notch (51).

5. The display terminal according to claim 1, wherein in a direction perpendicular to the axis of the rotating shaft (703), an opening width of the first notch (50) is greater than a width of the first bent portion (300).

6. The display terminal according to any one of claims 1 to 5, wherein the luminous area (101) is a rectangle; the first peripheral portion (40a) and the second peripheral portion (40b) are located on a long side of the luminous area (101).

7. The display terminal according to claim 6, wherein the flexible display screen (10) further comprises:
a first gate drive circuit (30a), wherein the first gate drive circuit (30a) is in the non-luminous area (102), and is disposed on a side on which a first short side of the luminous area (101) is located; and the first gate drive circuit (30a) is configured to provide a gate drive signal for at least a part of the luminous area (101); and
a second gate drive circuit (30b), wherein the second gate drive circuit (30b) is in the non-luminous area (102), and is disposed on a side on which a second short side of the luminous area (101) is located; and the second gate drive circuit (30b) is configured to provide a gate drive signal for at least a part of the luminous area (101), wherein
the first short side and the second short side are disposed opposite to each other.

8. The display terminal according to claim 7, wherein in a direction perpendicular to the axis of the rotating shaft (703), a width of the first gate drive circuit (30a) is the same as a width of the second gate drive circuit (30b).

## Patentansprüche

1. Anzeigeendgerät, das eine Trägerkomponente (70) und einen flexiblen Anzeigebildschirm (10) umfasst, wobei
die Trägerkomponente (70) ein erstes Gehäuse (701), ein zweites Gehäuse (702) und eine Drehwelle (703) umfasst; sich die Drehwelle (703) zwischen dem ersten Gehäuse (701) und dem zweiten Gehäuse (702) befindet; und das erste Gehäuse (701) und das zweite Gehäuse (702) durch Drehen der Drehwelle (703) verbunden sind; und
eine hintere Oberfläche des flexiblen Anzeigebildschirms (10) mit dem ersten Gehäuse (701), dem zweiten Gehäuse (702) und der Drehwelle (703) verbunden ist; ein Teil, der zu dem flexiblen Anzeigebildschirm (10) gehört und der mit der Drehwelle (703) verbunden ist, als ein erster gebogener Abschnitt (300) verwendet wird; und der erste gebogene Abschnitt (300) dazu konfiguriert ist, sich entlang einer Achse der Drehwelle (703) zu biegen, um einen Teil, der zu dem flexiblen Anzeigebildschirm (10)gehört und der separat mit dem ersten Gehäuse (701) und dem zweiten Gehäuse (702) verbunden ist, in zwei Hälften zu falten; und
der flexible Anzeigebildschirm einen leuchtenden Bereich (101) und einen nicht leuchtenden Bereich (102) aufweist, der an einem Rand des leuchtenden Bereichs (101) angeordnet ist; und wobei der flexible Anzeigebildschirm (10) Folgendes umfasst:
einen ersten Randabschnitt (40a) und einen zweiten Randabschnitt (40b); wobei sich der erste Randabschnitt (40a) und der zweite Randabschnitt (40b) in dem nicht leuchtenden Bereich (102) befinden und nebeneinander auf einer gleichen Seite des leuchtenden Bereichs (101) angeordnet sind; ein Teil, der zu dem ersten Randabschnitt (40a) gehört und der zu der hinteren Oberfläche des flexiblen Anzeigebildschirms (10) gebogen ist, dem ersten Gehäuse (701) zugewandt ist; und ein Teil, der zu dem zweiten Randabschnitt (40b) gehört und der zu der hinteren Oberfläche des flexiblen Anzeigebildschirms (10) gebogen ist, dem zweiten Gehäuse (702) zugewandt ist; und
eine erste Kerbe (50), wobei sich die erste Kerbe (50) in dem nicht leuchtenden Bereich (102) befindet, an einer Seite des ersten gebogenen Abschnitts (300) angeordnet ist und sich zwischen dem ersten Randabschnitt (40a) und dem zweiten Randabschnitt (40b) befindet; wobei der flexible Anzeigebildschirm (10) ferner eine Vielzahl von Datenleitungen umfasst; und **dadurch gekennzeichnet ist, dass**
jeder von dem ersten Randabschnitt (40a) und dem zweiten Randabschnitt (40b) jeweils einen Multiplexer (411) und eine Vielzahl von Pads (412), die mit dem Multiplexer (411) gekoppelt sind, umfasst; der Multiplexer (411) dazu konfiguriert ist, mit den Datenleitungen zu koppeln; und, nachdem der erste Randabschnitt (40a) in eine Richtung senkrecht zu der Achse der Drehwelle (703) gebogen wurde, der Multiplexer (411) und die Pads (412) auf der hinteren Oberfläche des flexiblen Anzeigebildschirms (10) angeordnet werden; wobei das Anzeigeendgerät (01) ferner einen Treiberchip (31), der mit den Pads (412) gekoppelt ist, umfasst.

2. Anzeigeendgerät nach Anspruch 1, wobei der flexible Anzeigebildschirm (10) ferner Folgendes umfasst:
einen Auffächerungsabschnitt (41), der sich zwischen dem leuchtenden Bereich (101) und den Randabschnitten befindet, wobei
der Auffächerungsabschnitt (41) eine Vielzahl von Auffächerungsleitungen umfasst; ein erstes Ende der Auffächerungsleitung mit dem Multiplexer (411) gekoppelt ist und ein zweites Ende mit der Datenleitung gekoppelt ist; und die Auffächerungsleitung nahe der ersten Kerbe (50) so angeordnet ist, dass sie eine Kante der ersten Kerbe (50) umgeht.

3. Anzeigeendgerät nach Anspruch 1, wobei der flexible Anzeigebildschirm (10) ferner einen dritten Randabschnitt (40c), einen vierten Randabschnitt (40d) und eine zweite Kerbe (51) umfasst; sich die zweite Kerbe (51) zwischen dem dritten Randabschnitt (40c) und dem vierten Randabschnitt (40d) befindet und sich der dritte Randabschnitt (40c), der vierte Randabschnitt (40d) und der erste Randabschnitt (40a) auf einer gleichen Seite des nicht leuchtenden Bereichs (102) befinden; und
Teile, die zu dem dritten Randabschnitt (40c) und dem vierten Randabschnitt (40d) gehören und die zu der hinteren Oberfläche des flexiblen Anzeigebildschirms (10) gebogen sind, beide dem ersten Gehäuse (701) zugewandt sind.

4. Anzeigeendgerät nach Anspruch 3, wobei die erste Kerbe (50) und die zweite Kerbe (51) eine gleiche Form aufweisen; und in einer Richtung senkrecht zu der Achse der Drehwelle (703) eine Öffnungsbreite der ersten Kerbe (50) die gleiche wie eine Öffnungsbreite der zweiten Kerbe (51) ist.

5. Anzeigeendgerät nach Anspruch 1, wobei in einer Richtung senkrecht zu der Achse der Drehwelle (703) eine Öffnungsbreite der ersten Kerbe (50) größer als eine Breite des ersten gebogenen Abschnitts (300) ist.

6. Anzeigeendgerät nach einem der Ansprüche 1 bis 5, wobei der leuchtende Bereich (101) ein Rechteck ist; und sich der erste Randabschnitt (40a) und der zweite Randabschnitt (40b) an einer langen Seite des leuchtenden Bereichs (101) befinden.

7. Anzeigeendgerät nach Anspruch 6, wobei der flexible Anzeigebildschirm (10) ferner Folgendes umfasst:
eine erste Gate-Treiberschaltung (30a), wobei sich die erste Gate-Treiberschaltung (30a) in dem nicht leuchtenden Bereich (102) befindet und auf einer Seite angeordnet ist, auf der sich eine erste kurze Seite des leuchtenden Bereichs (101) befindet;
und wobei die erste Gate-Treiberschaltung (30a) dazu konfiguriert ist, ein Gate-Treibersignal für mindestens einen Teil des leuchtenden Bereichs (101) bereitzustellen; und
eine zweite Gate-Treiberschaltung (30b), wobei sich die zweite Gate-Treiberschaltung (30b) in dem nicht leuchtenden Bereich (102) befindet und auf einer Seite angeordnet ist, auf der sich eine zweite kurze Seite des leuchtenden Bereichs (101) befindet;
und wobei die zweite Gate-Treiberschaltung (30b) dazu konfiguriert ist, ein Gate-Treibersignal für mindestens einen Teil des leuchtenden Bereichs (101) bereitzustellen, wobei
die erste kurze Seite und die zweite kurze Seite einander gegenüberliegend angeordnet sind.

8. Anzeigeendgerät nach Anspruch 7, wobei in einer Richtung senkrecht zu der Achse der Drehwelle (703) eine Breite der ersten Gate-Treiberschaltung (30a) die gleiche wie eine Breite der zweiten Gate-Treiberschaltung (30b) ist.

## Revendications

1. Terminal d'affichage, comprenant un composant de support (70) et un écran d'affichage flexible (10), dans lequel
le composant de support (70) comprend un premier boîtier (701), un second boîtier (702), et un arbre rotatif (703) ; l'arbre rotatif (703) est situé entre le premier boîtier (701) et le second boîtier (702) ; et le premier boîtier (701) et le second boîtier (702) sont reliés par la rotation de l'arbre rotatif (703) ; et
une surface arrière de l'écran d'affichage flexible (10) est reliée au premier boîtier (701), au second boîtier (702), et à l'arbre rotatif (703) ; une partie de l'écran d'affichage flexible (10) reliée à l'arbre rotatif (703) est utilisée comme première partie courbée (300) ; et la première partie courbée (300) est configurée pour se courber le long d'un axe de l'arbre rotatif (703), et replier en deux une partie de l'écran d'affichage flexible (10) reliée séparément au premier boîtier (701) et au second boîtier (702) ; et
l'écran d'affichage flexible comporte une zone lumineuse (101) et une zone non lumineuse (102) disposée à la périphérie de la zone lumineuse (101) ; et l'écran d'affichage flexible (10) comprend :
une première partie périphérique (40a) et une deuxième partie périphérique (40b) ; dans lequel la première partie périphérique (40a) et la deuxième partie périphérique (40b) se trouvent dans la zone non lumineuse (102) et sont disposées côte à côte sur un même côté de la zone lumineuse (101) ; une partie de la première partie périphérique (40a) courbée vers la surface arrière de l'écran d'affichage flexible (10) fait face au premier boîtier (701) ; et une partie de la deuxième partie périphérique (40b) courbée vers la surface arrière de l'écran d'affichage flexible (10) fait face au second boîtier (702) ; et
une première encoche (50), dans lequel la première encoche (50) est située dans la zone non lumineuse (102), disposée sur un côté de la première partie courbée (300), et située entre la première partie périphérique (40a) et la deuxième partie périphérique (40b) ; dans lequel l'écran d'affichage flexible (10) comprend également une pluralité de lignes de données ; et **caractérisé en ce que**
chacune de la première partie périphérique (40a) et de la deuxième partie périphérique (40b) comprend un multiplexeur (411) et une pluralité de plots (412) couplés au multiplexeur (411) ; le multiplexeur (411) est configuré pour se coupler aux lignes de données ; et après que la première (40a) partie périphérique est pliée dans une direction perpendiculaire à l'axe de l'arbre rotatif (703), le multiplexeur (411) et les plots (412) sont disposés sur la surface arrière de l'écran d'affichage flexible (10) ; dans lequel le terminal d'affichage (01) comprend également une puce de commande (31) couplée aux plots (412).

2. Terminal d'affichage selon la revendication 1, dans lequel l'écran d'affichage flexible (10) comprend également :
une partie de distribution en éventail (41), située entre la zone lumineuse (101) et les parties périphériques, dans lequel la partie de distribution en éventail (41) comprend une pluralité de fils de distribution en éventail ; une première extrémité du fil de distribution en éventail est couplée au multiplexeur (411), et une seconde extrémité est couplée à la ligne de données ; et le fil de distribution en éventail proche de la première encoche (50) est disposé en contournant un bord de la première encoche (50).

3. Terminal d'affichage selon la revendication 1, dans lequel l'écran d'affichage flexible (10) comprend également une troisième partie périphérique (40c), une quatrième partie périphérique (40d), et une seconde encoche (51) ; la seconde encoche (51) est située entre la troisième partie périphérique (40c) et la quatrième partie périphérique (40d), et la troisième partie périphérique (40c), la quatrième partie périphérique (40d), et la première partie périphérique (40a) sont situées du même côté de la zone non lumineuse (102) ; et
les parties de la troisième partie périphérique (40c) et de la quatrième partie périphérique (40d) pliées vers la surface arrière de l'écran d'affichage flexible (10) font toutes deux face au premier boîtier (701).

4. Terminal d'affichage selon la revendication 3, dans lequel la première encoche (50) et la seconde encoche (51) ont la même forme ; dans une direction perpendiculaire à l'axe de l'arbre rotatif (703), une largeur d'ouverture de la première encoche (50) est identique à une largeur d'ouverture de la seconde encoche (51).

5. Terminal d'affichage selon la revendication 1, dans lequel, dans une direction perpendiculaire à l'axe de l'arbre rotatif (703), une largeur d'ouverture de la première encoche (50) est supérieure à une largeur de la première partie courbée (300).

6. Terminal d'affichage selon l'une quelconque des revendications 1 à 5, dans lequel la zone lumineuse (101) est un rectangle ; la première partie périphérique (40a) et la deuxième partie périphérique (40b) sont situées sur un côté long de la zone lumineuse (101).

7. Terminal d'affichage selon la revendication 6, dans lequel l'écran d'affichage flexible (10) comprend également :
un premier circuit de commande de grille (30a), dans lequel le premier circuit de commande de grille (30a) est situé dans la zone non lumineuse (102), et est disposé sur un côté sur lequel se trouve un premier côté court de la zone lumineuse (101) ; et
le premier circuit de commande de grille (30a) est configuré pour fournir un signal de commande de grille pour au moins une partie de la zone lumineuse (101) ; et
un second circuit de commande de grille (30b), dans lequel le second circuit de commande de grille (30b) est situé dans la zone non lumineuse (102), et est disposé sur un côté sur lequel se trouve un second côté court de la zone lumineuse (101) ; et
le second circuit de commande de grille (30b) est configuré pour fournir un signal de commande de grille pour au moins une partie de la zone lumineuse (101), dans lequel
le premier côté court et le second côté court sont disposés en face l'un de l'autre.

8. Terminal d'affichage selon la revendication 7, dans lequel dans une direction perpendiculaire à l'axe de l'arbre rotatif (703), une largeur du premier circuit de commande de grille (30a) est la même qu'une largeur du second circuit de commande de grille (30b).
